# EUROPÄISCHE PATENTANMELDUNG

(11) **EP 2 522 700 A1**
(43) Veröffentlichungstag der Anmeldung: **14.11.2012**
(21) Anmeldenummer: 11165761.5
(22) Anmeldetag: 11.05.2011
(51) Int. Cl.: C09D 11/00, C09D 11/02, H01B 1/00, H01L 27/00, H01L 51/00

(54) **Wassersuspendierbare Druckpaste**

(71) Anmelder: Saint-Gobain Glass France, 92400 Courbevoie (FR)
(72) Erfinder: Alschinger, Matthias, 52134 Herzogenrath (DE); Kerbellec, Léa, 52070 Aachen (DE); Bergs, Bianca, 52511 Geilenkirchen (DE); Schmitz, Michael, 53913 Swissttal-Heimerzheim (DE)
(74) Vertreter: Lendvai, Tomas

(57) **Zusammenfassung**

Druckpaste mindestens enthaltend eine wässerige Suspension:
a. 30 Gew. % bis 83 Gew. % Wasser (A)
b. 0,2 Gew. % bis 40 Gew. % hydrophiles Polymer (B),
c. 1 Gew. % bis 35 Gew. % polares organisches Lösungsmittel (C) mit einem Dampfdruck kleiner 10 kPa und
d. 0,01 Gew. % bis 2 Gew. % Entschäumer (D).

## Beschreibung

Die Erfindung betrifft eine wassersuspendierbare Druckpaste, ein Verfahren zur Strukturierung eines Substrats und die Verwendung der Druckpaste.

Die Strukturierung dünner Schichten ist ein in der Technik weit verbreitetes Anwendungsgebiet. Wichtige Anwendungsbereiche sind Mikrochips und strukturierte Leiterplatten. Diese Leiterplatten bestehen im Wesentlichen aus elektrisch isolierenden Materialien, auf denen elektrische Verbindungen angebracht sind. Beispiele für isolierende Materialien sind Glas, nicht elektrisch leitfähige Polymere wie mit Epoxydharz getränkte Glasfaser, Teflon, Keramik und/oder Polyesterfolie. Die elektrischen Verbindungen wie beispielsweise Leitungsdrähte, enthalten bevorzugt Kupfer, Eisen, Zinn, Nickel, Gold und/oder Silber. Die Herstellung von strukturierten Substraten wie beispielsweise Leiterplatten erfolgt häufig in einem ersten Schritt durch das selektive Belichten eines photosensitiven Lackes auf einem Substrat. Alternativ kann die Strukturierung durch das Aufdrucken einer strukturgebenden Maske auf einem geeigneten Substrat erfolgen. Durch das Aufbringen der Maske wird ein Negativabdruck erzeugt. Das Substrat wird anschließend mit einer aktiven Schicht wie beispielsweise einer elektrisch leitenden oder isolierenden Schicht bedruckt. Nach dem Aushärten der aktiven Schicht wird die Maske anschließend wieder über einen chemischen oder physikalischen Prozess entfernt. Auf diese Art und Weise verbleibt die aktive Schicht nur in den Bereichen des Substrats, auf denen vorher keine Maske aufgetragen wurde. Die aktive Schicht liegt direkt auf dem Substrat auf.

Neben den Bereichen Mikrochips und Leiterplatten gewinnen auch im zunehmenden Maße strukturierte funktionelle Beschichtungen auf Substraten wie Glas und Polymeren an Bedeutung. Besonders Scheiben im Automobil- und Bauglasbereich werden immer mehr mit funktionellen Beschichtungen ausgerüstet, welche entsprechend strukturiert werden müssen. Beispiele hierfür sind funktionelle Verglasungen, elektrochrome Schichten, Dünnschichtsolarzellen und OLEDs. Organic Light Emitting Diods (OLEDs) bestehen häufig aus einer auf einem Glassubstrat aufgedampften Anode aus Indium-Zinn Oxid (ITO). An die Anode schließt sich eine Lochleitungsschicht, Farbstoffschicht (Emitterschicht) und die Kathode an. Zwischen den einzelnen Schichten werden in der Regel noch weitere Funktionsschichten angebracht, um den Transport von Elektronen und Löchern innerhalb des OLED - Aufbaus zu unterstützen. EP 2 086 007 A1 beschreibt die Funktionsweise. Bei Spannungsanlegung werden Löcher von der Anode und Elektronen von der Kathode emittiert. Bei der Kombination der Löcher und Elektronen werden in der Emitterschicht Pi-Elektronenübergänge induziert und elektromagnetische Strahlung in Form von sichtbarem Licht freigesetzt.

Auch elektrochrome Beschichtungen sind mögliche Anwendungsfelder. Die elektrochrome Beschichtung enthält mindestens eine inerte Deckschicht, eine elektrisch leitfähige Schicht, eine Elektrode und einen Elektrolyt. Der Elektrolyt enthält mindestens eine Elektronen isolierende Schicht und eine gehemmte elektrochrome Schicht. An den Elektrolyt schließt sich die zweite Elektrode, eine elektrisch leitfähige Schicht und ein Substrat an. Alle Schichten sind dabei im spannungslosen Zustand optisch transparent. Dies bedeutet bevorzugt eine Transmission für Licht der Wellenlängen von 300 nm bis 1300 nm von > 65 %, besonders bevorzugt > 75 %. Beispiele für elektrisch leitfähige Schichten sind Fluor dotiertes Zinndioxid (F:SnO₂) oder Zinn dotiertes Indiumoxid (ITO). Außerdem lassen sich Metalle oder Legierungen wie Silber, Kupfer, Gold oder Aluminium, gegebenenfalls zusammen mit Promotoren wie Ni/Cr Legierungen verwenden. Die Elektroden können als Kathode, wie beispielweise Wolframoxid (WO₃), oder als Anode, wie beispielsweise Nickeloxide (NiOₓH_{y}), (NiOₓ) oder Iridiumoxide (IrOₓ.) ausgebildet sein. Die Reihenfolge ist dabei variabel. Der Elektrolyt enthält mindestens eine elektrisch isolierende Schicht, beispielsweise hydriertes Tantaloxid (Ta₂O₅*nH₂O), Antimonoxid (Sb₂O₃) Zirkoniumdioxid (ZrO₂) und/oder Titandioxid (TiO₂). Die gehemmte elektrochrome Schicht enthält beispielsweise hydriertes Wolframoxid (WO₃*nH₂O), Nioboxid (Nb₂O₃), (Nb₂O₃*nH₂O), Zinnoxid (SnO₂), (SnO₂*nH₂O) und/oder Bismutoxid (Bi₂O₃), (Bi₂O₃*nH₂O). Auch ein dreigliederiger sandwichartiger Schichtaufbau wie beispielsweise Ta₂O₅*nH₂O/WO₃*nH₂O/Ta₂O₅*nH₂O ist möglich.

US 6,277,523 B1 beschreibt die Bau- und Funktionsweise einer elektrochromen Beschichtung. Dabei lässt sich die Transparenz für Licht verschiedener Wellenlängen durch Anlegen einer elektrischen Ladung steuern und regulieren.

US 2003/0129784 A1 offenbart ein Verfahren zur Herstellung von OLEDs. Das Verfahren beinhaltet eine selektive Beschichtung zur Strukturierung der OLEDs. Die Strukturierung kann dabei über verschiedene Druckverfahren, beispielsweise Ink-Jet Verfahren erfolgen.

US 2004/0123799 A1 offenbart eine abziehbare Maske für die Oberflächenstrukturierung von OLEDs sowie ein Verfahren für deren Montage. Die Maske erlaubt ein Vakuumabscheiden von strukturiertem organischen und anorganischen Material.

EP 2 086 007 A1 offenbart eine OLED und ein Verfahren zu deren Herstellung. Die Strukturierung kann über einen photolithographischen Prozess und anschließenden Ätzschritt erfolgen.

EP 1 939 685 A2 offenbart ein Maske und ein Verfahren zu deren Anwendung bei der Herstellung von OLEDs. Das Verfahren beinhaltet das Aufbringen eines photosensitiven Lacks und die Positionierung einer Maske über den entsprechenden Bereichen eines Substrates. Anschließend werden das Substrat und die maskierten Bereiche UV-Strahlung ausgesetzt. Das Verfahren wird durch einen Lösungs- und Ätzprozess abgeschlossen.

Der gesamte photolithographische Prozess beinhaltet viele einzelne und prozesstechnisch aufwendige Schritte. Insbesondere das Aufbringen, Aushärten und Entfernen des photosensitiven Lacks ist sehr aufwendig und zeitintensiv. Hinzu kommt noch der notwendige Einsatz von organischen Lösungsmitteln, welche zwangsläufig weitere Begleitprozesse notwenig machen. So sind organische Lösungsmittel in vielen Fällen gesundheitsschädlich und flamm- bzw. explosionsgefährlich. Zudem müssen organische Lösungsmittel häufig aufwendig abgetrennt und entsorgt werden. Weitergehende Verschärfung der Chemikalienrichtlinien werden in diesem Bereich zum Ersatz bedenklicher Prozesschemikalien und zu weiteren Verteuerungen führen.

Die Aufgabe der vorliegenden Erfindung liegt darin, eine Paste zur Herstellung von strukturierten Beschichtungen bereitzustellen, welche ohne oder nur mit geringem Lösungsmitteleinsatz entfernt werden kann und die Exposition flüchtiger Kohlenwasserstoffe (VOC, Volatile Organic Compounds) minimiert wird.

Die Aufgabe der vorliegenden Erfindung wird erfindungsgemäß durch eine Paste gemäß dem unabhängigen Anspruch 1 gelöst. Bevorzugte Ausführungen gehen aus den Unteransprüchen hervor.

Ein erfindungsgemäßes Verfahren zur Herstellung strukturierter beschichteter Oberflächen und die erfindungsgemäße Verwendung des Verfahrens für die Herstellung von OLEDs gehen aus weiteren unabhängigen Ansprüchen hervor.

Die erfindungsgemäße wassersuspendierbare Druckpaste enthält mindestens Wasser (A), ein wasserlösliches oder hydrophiles Polymer (B), ein polares organisches Lösungsmittel (C) mit einem Dampfdruck kleiner 10 kPa (gemessen bei 20 °C und 1 bar Druck) und einen Entschäumer (D).

Die Druckpaste enthält 30 Gew. % bis 83 Gew. % Wasser, bevorzugt 35 Gew. % bis 60 Gew. % Wasser. Hydrophile Polymere umfassen auch Copolymere und Blockcopolymere mit Monomereinheiten aus polaren Funktionellen Gruppen wie, (-O-CH₂-CH₂), Hydroxyl-, Keton- Carboxyl-, Thiol-, Amin-, Amid-, Imidgruppen.

Die Druckpaste enthält 0,2 Gew. % bis 40 Gew. %, bevorzugt 15 Gew. % bis 35 Gew. % hydrophile Polymere. Polare organische Lösungsmittel umfassen im Sinne der Erfindung sowohl polar-protische Lösungsmittel als auch polar-aprotische Lösungsmittel. Die Dielektrizitätskonstante ε (W.M. Haynes, Handbook of Chemistry and Physics, 91st Edition, CRC Press, 15-13, 2010.) ist jeweils bevorzugt größer als 5. Der niedrige Dampfdruck des polaren organischen Lösungsmittels (C) verhindert ein zu schnelles Verdampfen des wässrigen Lösungsmittels. Die Druckpaste enthält 1 Gew. % bis 35 Gew. %, bevorzugt 15 Gew. % bis 25 Gew. % polare organische Lösungsmittel. Die Druckpaste kann als Suspension, Emulsion oder auch als viskose Lösung vorliegen.

Die Druckpaste enthält 0,01 Gew. % bis 5 Gew. %, bevorzugt 0,05 Gew. % bis 2 Gew. % Entschäumer. Zugesetzte Entschäumer wie beispielsweise Alkohole reichern sich in der Grenzschicht zwischen der Druckpaste und der Luft an und verringern so die Schaumstabilität. Eine starke Schaumbildung würde die durch die Polymermaske vorgezeichneten Strukturen verwischen oder verbreitern.

Die Herstellung der Druckpaste kann in der dem Fachmann bekannten Art und Weise durch Vermischen der einzelnen Bestandteile erfolgen. Die Bestandteile können zur besseren Homogenisierung in einem geeigneten Gefäß in ein Ultraschallbad überführt werden. Die entstehende Mischung kann anschließend noch auf 70 °C bis 150 °C, bevorzugt 90 °C bis 140 °C erhitzt werden. Zur Verbesserung der Mischbarkeit kann die Druckpaste noch nichtionische, ionische und/oder amphotere Tenside enthalten. Die Druckpaste weist bevorzugt eine Viskosität von > 5 mPa s, bevorzugt größer 10 mPa s auf.

Das wasserlösliche Polymer enthält bevorzugt Polyethylenoxide, Polypropylenoxide, Polysaccharide, Polyalkohohle, Polyvinylalkohole, Polyacetate, Polyvinylacetate, Polyurethane, Polyamide und/oder Gemische oder Copolymere davon.

Das wasserlösliche Polymer enthält besonders bevorzugt Polyethylenoxid, Polypropylenoxid, Hydroxpropylcellulose, Stärke, Cellulose, Amylose, Amylopektin, Xanthan, Alginate, Carrageen und/oder Gemische oder Copolymere davon.

Die Druckpaste enthält bevorzugt 15 Gew. % bis 35 Gew. % PVA (Polyvinylalkohol) mit einem Molekulargewicht von 20000 g/mol bis 150000 g/mol und einer Esterzahl von 100-180 mg KOH/g (PVA) gemessen nach DIN 53 401. Der Verseifungsgrad beträgt bevorzugt 70 mol % bis 99,5 mol %. Das PVA weist bevorzugt eine Viskosität von 3 mPa s bis 20 mPa s, besonders bevorzugt 3,5 mPa s bis 10 mPa s auf, gemessen als 4 Gew. % wässrige Lösung bei 20 °C.

Der Entschäumer enthält bevorzugt Alkohole mit 1 bis 12 Kohlenstoffatomen, Glyceride von Fettsäuren, Glyceride von Fettsäureestern, Polydimethylsiloxane und/oder Gemische davon.

Das polare organische Lösungsmittel weist bevorzugt einen Dampfdruck von < 5 kPa, bevorzugt < 1 kPa auf. Der niedrigere Dampfdruck der resultierenden Mischung ermöglicht die Nutzung von geringeren Anteilen des polaren organischen Lösungsmittels in der Druckpaste.

Das polare organische Lösungsmittel enthält bevorzugt Ethylenglykol (Glykol), Glycerin, Propylenglykol, Buthylglykol und/oder Gemische davon.

Die Druckpaste enthält bevorzugt einen wasserlöslichen Farbstoff, besonders bevorzugt Fluoreszin, Methylenblau, Blütenextrakte und/oder Lebensmittelfarben wie Azorubin, Carotin, Chlorophyll, Curcumin, Brilliantblau oder Anthocyan.

Die Erfindung umfasst des Weiteren ein Verfahren zur Substratstrukturierung. In einem ersten Schritt wird eine erfindungsgemäße Siebdruckpaste entsprechend einer vorher definierten Maske auf ein Substrat aufgetragen. Das Substrat umfasst dabei bevorzugt Substrate aus Glas oder Polymer. Im nächsten Schritt wird eine aktive Schicht auf das Substrat und die Siebdruckpaste aufgetragen. Die aktive Schicht umfasst im Sinne der Erfindung Metall- und organische Schichten, wie Silber, Gold, Kupfer, Wolfram, Aluminium, Zinn, Zink, Indium, oder organische Schichten wie Farbstoffe und elektrisch leitfähige Polymere. Beispiele für aktive funktionelle Schichten in OLEDs sind Anoden (z.B. aus Indium-Zinn Oxid (ITO)), Lochleitungsschicht, Farbstoffschicht (Emitterschicht) und/oder Kathoden. In einem abschließenden Schritt wird die Druckpaste mit einem wässrigen Lösungsmittel mit mindestens 90 Gew. % Wasser entfernt. Das wässrige Lösungsmittel enthält bevorzugt keine zugesetzte Säure, Base oder organische Lösungsmittel. Das wässrige Lösungsmittel hat bevorzugt einen pH-Wert von 6-8. Das wässrige Lösungsmittel enthält bevorzugt keine zugesetzten Elektronen oxidierende oder reduzierende Zusätze wie beispielsweise Peroxide oder gelöste Zinn- und Zinksalze. Der Ausdruck "zugesetzt" bedeutet im Sinne der Erfindung einen Anteil an (Rest-)Verunreinigungen von weniger als 1 mg/l an den oben beschriebenen Verbindungen. Mit der Ablösung der Druckpaste wird an diesen Stellen des Substrats auch die aktive Schicht selektiv entfernt, sodass sich eine Oberflächenstrukturierung oder Musterung im Bereich der jetzt fehlenden Druckpaste ergibt.

Das wässrige Lösungsmittel enthält bevorzugt mindestens 95 Gew. %, besonders bevorzugt mindestens 98 Gew. %, insbesondere bevorzugt mindestens 99 Gew. % Wasser. Der Reinheitsgrad des wässrigen Lösungsmittels richtet sich nach der jeweiligen Anwendung.

Die Druckpaste wird bevorzugt über ein Druckverfahren, besonders bevorzugt Siebdruckverfahren oder Ink-Jet-Verfahren aufgetragen.

Die Druckpaste wird bevorzugt in einer Schichtdicke von 10 µm bis 50 µm, besonders bevorzugt 15 µm bis 35 µm aufgetragen.

Die aktive Schicht wird bevorzugt durch CVD (chemical vapor deposition / Chemische Gasphasenabscheidung) oder PVD (physical vapor deposition), besonders bevorzugt über Sputtern oder Magnetronsputtern auf dem Substrat aufgetragen. Das Auftragen erfolgt bevorzugt bei Raumtemperatur. Das Substrat wird bevorzugt, außer durch den Beschichtungsvorgang, nicht weiter erwärmt.

Die aktive Schicht wird bevorzugt in einer Schichtdicke von 10 nm bis 1000 nm, bevorzugt 150 nm bis 700 nm aufgetragen.

Die aktive Schicht enthält bevorzugt Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), Aluminium, Zink, Indium, Chrom, Gallium, Silber, Gold, Zinn, Wolfram, Kupfer, Cadmium, Niob, Strontium, Silizium, Zink, Selen und/oder Gemische oder Legierungen davon.

Die aktive Schicht wird bevorzugt als Multilayer aufgetragen.

Die Erfindung umfasst des Weiteren die Verwendung der erfindungsgemäßen Druckpaste zur Herstellung von strukturierten Substraten, bevorzugt strukturierten Leiterplatten, besonders bevorzugt zur Herstellung von OLEDs, elektrochrome Schichten und Solarzellen.

Eine bevorzugte Mischung der Druckpaste enthält 30 Gew. % PVA (Mowiol^{®} 4-88, Kuraray, Frankfurt, Deutschland), 20 Gew. % Glykol, 0,3 Gew. % bis 1 Gew. % Entschäumer (Agitan^{®} 295, Münzing Chemie GmbH, Heilbronn, Deutschland) und 49 Gew. % bis 49,7 Gew. % Wasser.

Im Folgenden wird die Erfindung anhand von Zeichnungen und einem Beispiel näher erläutert. Die Zeichnungen sind rein schematische Darstellungen und nicht maßstabsgetreu. Sie schränken die Erfindung in keiner Weise ein.

Es zeigen:
Figur 1 Querschnitte der erfindungsgemäßen Verfahrensschritte und
Figur 2 eine durch das erfindungsgemäße Verfahren hergestellte strukturierte Beschichtung.

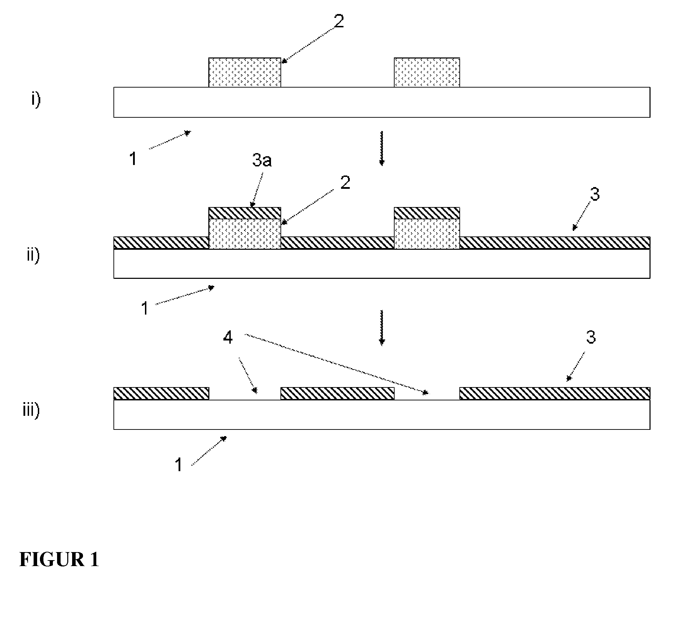

Figur 1 zeigt eine schematische Skizze des erfindungsgemäßen Verfahrens. In einem ersten Schritt i) wird eine erfindungsgemäße Druckpaste (2) enthaltend Wasser (A), ein wasserlösliches oder hydrophiles Polymer (B), ein polares organisches Lösungsmittel (C) mit einem Dampfdruck kleiner 10 kPa, gemessen bei 20 °C und 1 bar Druck, und ein Entschäumer (D) auf einem Substrat (1) aufgebracht. Nach einem kurzen Trockenvorgang der Druckpaste (2) wird in Schritt ii) die aktive Schicht aus ITO (Indiumzinnoxid) über Sputtern in einer Schichtdicke von 10 nm bis 1000 nm, bevorzugt 150 nm bis 700 nm flächenmäßig aufgetragen. In einem abschließenden Schritt iii) werden die Druckpaste (2) und die darauf befindliche aktive Schicht (3a) mit destilliertem Wasser (F) (in Figur 1 nicht gezeigt) abgespült. Der Spülvorgang kann je nach Anwendungsbereich noch mehrere Male mit hochreinem Wasser wiederholt werden. Die nach dem Spülvorgang zurückbleibenden, strukturierten und nicht beschichteten Bereiche sind in Figur 1 unter (4) gezeigt.

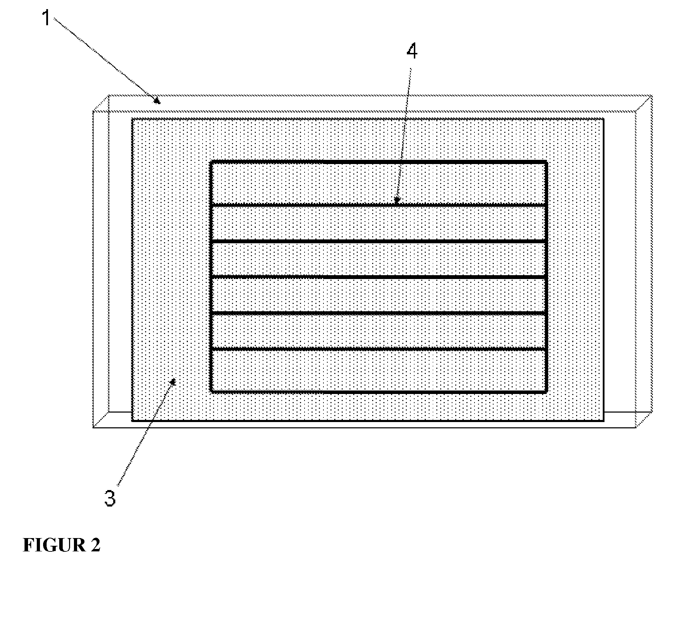

Figur 2 zeigt eine durch das erfindungsgemäße Verfahren hergestellte strukturierte Beschichtung. Auf einem Glassubstrat (1) befinden sich eine aktive Schicht (3) und der durch die ausgewaschene Druckpaste (2) definierte strukturierte Bereich (4). Die Auflösung oder Druckschärfe der strukturierten Bereiche (4) wird durch die Auflösung des Druckverfahrens und die Viskosität der Druckpaste bestimmt.

### Beispiel

Es wurde eine erfindungsgemäße Paste 1 und eine Vergleichspaste 2 gemäß der Zusammensetzung in Tabelle 1 durch Vermischen und Homogenisieren der Komponenten hergestellt.

**Tabelle 1: Zusammensetzung von Paste 1 und der Vergleichspaste 2**

| | Paste 1 | Vergleichspaste 2 |
|---|---|---|
| Wasser [Gew. %] | 54,5 | 83 |
| PVA [Gew. %] | 30 (Mowiol^{®} 4-88) | 17 (Mowiol^{®} 18-88) |
| Glykol [Gew. %] | 15 | - |
| Entschäumer [Gew. %] | 0,5 (Agitan^{®} 295) | - |

Mit beiden Pasten wurden mit einem Siebdruckverfahren Kammstrukturen in einer mittleren Breite von 500 µm auf ein Glassubstrat gedruckt und anschließend die Auflösung und Substrathaftung der gedruckten Linien im Lichtmikroskop beurteilt. Die Ergebnisse zeigt Tabelle 2. Die mit Paste 1 gedruckten Linien zeigen eine klare Linienschärfe und eine vernachlässigbare Ausfransung. Die mit der Vergleichspaste 2 gedruckten Strukturen sind stark verwaschen und eignen sich nicht als Vorlage für eine Oberflächenstrukturierung. Diese Ergebnisse waren überraschend und nicht naheliegend.

**Tabelle 2: Beurteilung der Auflösung und Substrathaftung**

| | Paste 1 | Vergleichspaste 2 | |
|---|---|---|---|
| Linienschärfe | klar sichtbar | verwaschen, ausgefranst | |
| Substrathaftung | gute Haftung der Paste | schlechte Haftung der Paste | |

### Bezugszeichenliste

- (A): Wasser
- (B): hydrophiles Polymer
- (C): polares organisches Lösungsmittel
- (D): Entschäumer
- (E): Farbstoff
- (F): wässrigen Lösungsmittel
- (1): Substrat
- (2): Druckpaste
- (3): aktive Schicht
- (3a): aktive Schicht auf der Druckpaste
- (4): durch abgelöste Druckpaste strukturierter Bereich

## Patentansprüche

1. Druckpaste mindestens enthaltend eine wässerige Suspension:
a. 30 Gew. % bis 83 Gew. % Wasser (A)
b. 0,2 Gew. % bis 40 Gew. % hydrophiles Polymer (B),
c. 1 Gew. % bis 35 Gew. % polares organisches Lösungsmittel (C) mit einem Dampfdruck kleiner 10 kPa und
d. 0,01 Gew. % bis 2 Gew. % Entschäumer (D).

2. Druckpaste nach Anspruch 1, wobei das hydrophile Polymer (B) Polyethylenoxide, Polysaccharide, Polyalkohohle, Polyvinylalkohole, Polyacetate, Polyurethane, Polyvinylacetate, Polyamide und/oder Gemische oder Copolymere, bevorzugt Polyethylenoxid, Polypropylenoxid, Carboxymethylcellulose, Hydroxpropylcellulose, Stärke, Amylose, Amylopektin, Xanthan, Alginate, Carrageen, Guakernmehl, Johannisbrotkernmehl und/oder Gemische oder Copolymere davon enthält.

3. Druckpaste nach Anspruch 1 oder 2, wobei das hydrophile Polymer (B) Polyvinylalkohol (PVA) mit einem Molekulargewicht von 15000 g/mol bis 150000 g/mol und einer Esterzahl von 100 mg - 180 mg KOH/g enthält.

4. Druckpaste nach einem der Ansprüche 1 bis 3, wobei das polare organische Lösungsmittel (C) einen Dampfdruck von < 5 kPa, bevorzugt < 1 kPa aufweist.

5. Druckpaste nach einem der Ansprüche 1 bis 4, wobei das polare organische Lösungsmittel (C) Ethylenglycol, Glycerin, Propylenglycol, Buthylglycol, N-Methyl-2-Pyrrolidon und/oder Gemische davon enthält.

6. Druckpaste nach einem der Ansprüche 1 bis 5, wobei der Entschäumer (D) Alkohole mit 1 bis 12 Kohlenstoffatomen, Glyceride von Fettsäuren, Glyceride von Fettsäureester, Polydimethylsiloxane und/oder Gemische davon enthält.

7. Druckpaste nach einem der Ansprüche 1 bis 6, wobei die Druckpaste einen wasserlöslichen Farbstoff (E), bevorzugt Fluoreszin, Methylenblau und/oder Lebensmittelfarben enthält.

8. Verfahren zur Substratstrukturierung, wobei
a. eine Druckpaste (2) nach einem der Ansprüche 1 bis 7 auf ein Substrat (1) in einem Muster oder einer Strukturierung aufgetragen wird,
b. eine aktive Schicht (3) auf die Druckpaste (2) und auf das Substrat (1) aufgetragen wird und
c. die Druckpaste (2) mit einem wässrigen Lösungsmittel (F) mit mindestens 90 Gew. % Wasser entfernt wird, wobei eine Musterung der aktiven Schicht (3) auf dem Substrat (1) erhalten wird.

9. Verfahren nach Anspruch 8, wobei die Druckpaste (2) mit dem wässrigen Lösungsmittel (F) mit mindestens 95 Gew. %, bevorzugt mindestens 98 Gew. %, besonders bevorzugt mindestens 99 Gew. % Wasser abgewaschen wird.

10. Verfahren nach Anspruch 8 oder 9, wobei die Druckpaste (2) über ein Druckverfahren, bevorzugt Siebdruckverfahren oder Ink-Jet-Verfahren aufgetragen wird.

11. Verfahren nach einem der Ansprüche 8 bis 10, wobei die Druckpaste (2) in einer Schichtdicke von 10 µm bis 50 µm, bevorzugt 15 µm bis 35 µm aufgetragen wird.

12. Verfahren nach einem der Ansprüche 8 bis 11, wobei die aktive Schicht (3) über PVD-Verfahren (Physikalische Gasphasenabscheidung) oder CVD-Verfahren (Chemische Gasphasenabscheidung), bevorzugt Sputtern oder Magnetronsputtern aufgetragen wird.

13. Verfahren nach einem der Ansprüche 8 bis 12, wobei die aktive Schicht in einer Schichtdicke von 10 nm bis 1000 nm, bevorzugt 150 nm bis 700 nm aufgetragen wird.

14. Verfahren nach einem der Ansprüche 8 bis 13, wobei die aktive Schicht enthaltend Zinn-dotiertes Indiumoxid (ITO), Aluminium-dotiertes Zinkoxid (AZO), Fluor-dotiertes Zinnoxid (FTO, SnO₂:F), Antimon-dotiertes Zinnoxid (ATO, SnO₂:Sb), Aluminium, Zink, Indium, Gallium, Silber, Gold, Chrom, Zinn, Wolfram, Kupfer, Cadmium, Niob, Strontium, Silizium, Zink, Selen und/oder Gemische oder Legierungen davon aufgetragen wird.

15. Verwendung der Druckpaste nach einem der Ansprüche 1 bis 7 zur Herstellung von strukturierten Substraten, bevorzugt strukturierten Leiterplatten, besonders bevorzugt zur Herstellung von OLEDs, elektrochrome Schichten auf Verglasungen oder Solarzellen.
